Europäisches Patentamt

European Patent Office

Office européen des brevets

(11) Publication number: **0 457 415 A1**

# EUROPEAN PATENT APPLICATION

(21) Application number: 91202023.7

(22) Date of filing: 12.11.86

(51) Int. Cl.⁵: **C23C 16/54**, C23C 16/50, C23C 16/48, H01L 21/205

This application was filed on 06 - 08 - 1991 as a divisional application to the application mentioned under INID code 60.

(30) Priority: 12.11.85 JP 253299/85
18.11.85 JP 259194/85

(43) Date of publication of application:
21.11.91 Bulletin 91/47

(60) Publication number of the earlier application in accordance with Art.76 EPC: **0 224 360**

(84) Designated Contracting States:
DE FR GB

(71) Applicant: SEMICONDUCTOR ENERGY LABORATORY CO., LTD.
398 Hase
Atsugi-shi Kanagawa-ken, 243(JP)

(72) Inventor: Yamazaki, Shunpei
21-21 Kitakarasuyama 7-chome
Setagaya-ku, Tokyo 157(JP)

(74) Representative: Burke, Steven David et al
R.G.C. Jenkins & Co. 26 Caxton Street
London SW1H 0RJ(GB)

(54) Semiconductor device manufacturing method.

(57) An improved semiconductor device manufacturing system and method is disclosed in which undesirable sputtering can be averted by virtue of the combination of an ECR system and a CVD system. Prior to the deposition of a semiconductor layer by the ECR/CVD combination, a sub-layer can be formed on a substrate in a reaction chamber and transported to another chamber for deposition to be effected according to the ECR/CVD combination without the substrate being exposed to contact with air, so that a semiconductor junction thus formed has good characteristics.

FIG.2

This invention concerns improvements relating to semiconductor device manufacturing methods.

A plasma CVD (chemical vapour deposition) system in which reactant gas is made active by glow discharge alone, has been proposed and is considered advantageous as compared with more conventional thermal CVD systems for semiconductor material deposition in that the deposition process can be carried out at a relatively low temperature. Further, the deposited layer thus formed contains hydrogen or halogen as a recombination centre neutralizer, which can improve p-n, n-i or p-i junctions formed in the layer. Such a glow discharge CVD system however, obtains only very low deposition speeds, and there is a requirement to increase such speeds by a factor of 10 to 500 to satisfy the needs of commercial availability.

A CVD system enhanced by ECR (electron cyclotron resonance) has also been proposed in which deposition is carried out at pressures lower than 1.333 Pa ($1 \times 10^{-2}$ torr), e.g., 1.333 to 1.333 x $10^{-3}$ Pa ($1 \times 10^{-2}$ to $1 \times 10^{-5}$ torr). By virtue of such a CVD/ECR system, a $5 \times 10^{-7}$m (5000 Å) to 10 microns thick layer can be deposited at a rate of $10^{-9}$ to $10^{-8}$ m/s (10 to 100 Å/sec). However, when a plurality of layers are desired to be deposited, the system is still very slow.

It would therefore be desirable to provide an improved semiconductor manufacturing method which is capable of producing semi conductor devices with high quality junctions; to provide an improved semiconductor manufacturing method which is capable of yielding large throughput; and to provide an improved semiconductor manufacturing method with a short process time.

Aspects of the invention are set out in the accompanying claims. According to an illustrative and exemplary embodiment of the present invention, non-productive gas such as argon for example is energized by electron cyclotron resonance (ECR). The thus activated non-productive gas is then applied to transfer a part of its energy to productive gas in a glow discharge CVD system, so that an intrinsic layer can be deposited without any sputtering effect on a sub-layer (an impurity semiconductor layer for example) which has previously been formed on a substrate. By virtue of this technique, the tendency for glow discharge CVD to damage a substrate by its accompanying sputtering effect can largely be overcome.

In the practice of the inventive technique above-described a multi-chamber system can be utilized in which a plurality of depositions can be made in succession without exposing a substrate being processed to contact with air. As a result, semiconductor junctions can be protected from atmospheric contamination and particularly from lower oxide or lower nitride incursions.

The combination of an ECR system and a glow discharge CVD system also makes it possible to perform depositions at a high operational speed and obtain high quality products.

In the practice of the present invention, depositions are preferably made at a low pressure of the order of 1.333 x $10^{-3}$ to 1.333 Pa ($10^{-5}$ to $10^{-2}$ torr) and preferably around 1.333 x $10^{-2}$ to 1.333 x $10^{-1}$ Pa ($10^{-4}$ to $10^{-3}$ torr), which is a very low pressure as compared with the pressure used in carrying out prior art techniques, namely about 13.33 to 66.66 Pa (0.1 to 0.5 torr). The use of such low pressure reduces residual gas retention in the process chamber between one deposition process and the next, making it possible to streamline the manufacturing process by including a plurality of deposition steps carried out in different chambers and dispensing with the need to evacuate one chamber sufficiently and then open a valve partitioning it from the next chamber before effecting successive depositions in sequential chambers.

As a reactant (productive) gas, a silicide gas such as $Si_nH_{2n+1}$ ($n \geq 1$), $SiF_n$ ($n \geq 2$), $SiH_nF_{4-n}$ - ($1 < n < 4$) or $Si(CH_3)_nH_{4-n}$ ($n = 1,2,3$), a germanium composition such as $GeH_4$, $GeF_4$ or $GeH_nF_{4-n}$ - ($n = 1,2,3,4$), a tin compound such as $SnCl_4$ or $SnF_2$ or $SnF_4$, or a carbide gas can be employed, for example. In addition, a dopant gas such as $B_2H_6$, $BF_3$ or $PH_3$ for example may be added for fabrication of impurity semiconductor layers.

Other features of the invention are set forth with particularity in the appended claims, and the invention together with features and advantages thereof will best be understood from consideration of the following description of exemplary embodiments given with reference to the accompanying drawings wherein:-

Fig. 1 is a schematic diagrammatic representation of an exemplary ECR enhanced CVD system; and

Fig. 2 is a schematic diagrammatic representation of an exemplary multi-chamber processing system used in a method embodying the present invention.

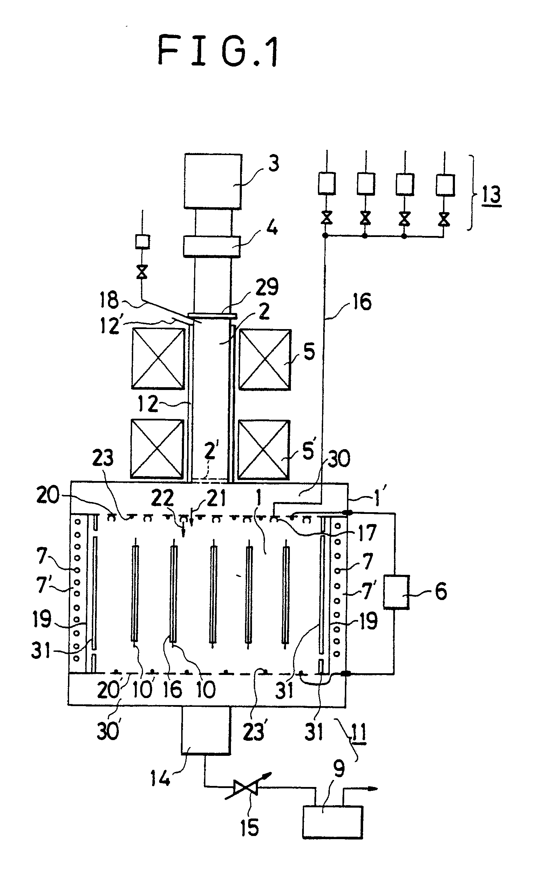

Referring to Fig. 1, an ECR enhanced CVD system used in a method according to the invention is shown. A reaction chamber 1 communicates with loading and unloading chambers (not shown) on opposite sides of the reaction chamber 1 perpendicular to the plane of the drawing, the reaction chamber and the loading and unloading chambers communicating with each other through gate valves. Between the loading and unloading chambers, a reaction space is surrounded by collars 31 and 31' made of stainless steel and/or insulating material so that excited reactive gas does not spread out to the inside of the structure and does not give rise to the accumulation of products which might become a source of flakes in a deposited semiconductor layer. The collars 31' are formed and arranged to constitute an enclosure in co-operation with the collars 31, the three collars on each side of the enclosure being made flush with each other. The collar 31 is formed with five substrate holders 10' and is capable of being removably mounted in the reaction chamber 1 as shown in the figure, and substrates 10 can be mounted on both sides of each holder 10'. With the reaction space therebetween, halogen lamp heaters 7 are provided to irradiate the collars 31 and the substrates 10 on the holders 10' with infrared radiation. Further, a pair of meshed grids 20 and 20' are provided at the upper and lower sides of the reaction space 1. A glow discharge is established in the reaction space 1 by applying to the grids 20 and 20' an alternating electric field of 13.56 MHz for example or by applying a direct electric field between the meshed electrodes 20 and 20' by means of a power supply 6.

Above the reaction chamber, a resonant space is defined by the interior of a resonance chamber 2, and non-productive gas can be introduced into the resonant space through a line 18. The resonant space can be subjected to a magnetic field by energizing a coreless coil 5 and 5', a Helmholtz coil 5 and 5' surrounding the resonant space in this embodiment. A cooling circuit 12 is arranged around the resonance chamber 2. Further, microwave energy can be radiated into the resonant space from a microwave oscillator 3 via an isolator 4 through a window made of synthetic quartz.

The non-productive gas introduced and excited in the resonant space might for example be argon and the magnitude of the magnetic field might for example be chosen at $8.75 \times 10^{-2}$T (875 Gauss), the magnitude of the magnetic field and the frequency of the microwave energy in general being determined according to the molecular weight of the non-productive gas to be excited. The argon gas thus excited is pinched by the magnetic field and resonates with the microwave energy on the background of the magnetic field. The excited argon gas is rendered to the reaction space 1 through an extraction grid 2'. Between the grid 2' and the reaction space 1 there is a buffer space 30 and a plurality of nozzles 23 through which productive gas may be introduced throughout the reaction space. The productive gas is mixed with the excited non-productive gas and is itself excited by transfer of energy from the non-productive gas. The meshed electrode 20 functions also as a homogenizer to prevent the excited gas from backflowing. In the case where the collars are made of insulating material, a pair of insulator grids may be used as a homogenizer and a plurality of electrodes may be provided to produce the requisite electron discharge. In order to distribute the reaction gas throughout the reaction chamber 1 and establish cyclotron resonance, the pressure in the resonant space and the reaction space is chosen to be around $1.333 \times 10^{-1}$ to $1.333 \times 10^{-2}$ Pa ($1 \times 10^{-3}$ to $1 \times 10^{-4}$ torr), $4 \times 10^{-2}$ Pa ($3 \times 10^{-4}$ torr) for example. The pressure is adjusted by controlling the exhausting rate of a vacuum pump 9 by means of a controlling valve 15 in co-operation with a turbo pump 14.

By virtue of the described arrangement, electrons and the excited gas 21 traverse the reaction chamber. Even with a substantial distance between the resonant space and the surfaces of the substrates, the excitations of the productive gas derived from the resonating gas is manifest in the vicinity of the substrates. When cyclotron resonance has been used alone as in the prior art, this distance has been chosen to be about 5 to 15 cm. While a short distance between the resonant space and the substrates reduces energy loss in the excited gas, it has resulted in deposited layers being uneven.

An amorphous silicon layer was fabricated according to the above described system as follows. Namely, a reaction chamber of 40 cm height and 50 cm width and length was utilized which defined a reaction space of 30 cm height and 35 cm width and length. Ten substrates 10 were placed on the holder. Argon gas was introduced into the reaction space 1 under a pressure of $4 \times 10^{-2}$ Pa ($3 \times 10^{-4}$ torr) as a non-productive gas through the line 18 at a rate of 200 cc/min. Also monosilane gas was introduced through the line 16 at a rate of 80 cc/min. In addition to this, $B_2H_6$ gas diluted with $SiH_4$ for example may be leaked simultaneously at from 0.1 to 10 ppm to make a substantially intrinsic semiconductor, if desired. High-frequency electric energy at 40 W was initially supplied by the power source 6, and microwave energy at a frequency of 2.45 GHz and a power of from 200 W to 800 W, preferably 400 W, was also supplied. The magnitude of the magnetic field was chosen at $0.0875 \pm 0.01$ T ($875 \pm 100$ Gauss).

The substrate 10 was provided with a conductive transparent layer. On the substrate 10 was deposited a non-monocrystal semiconductor layer, for example an amorphous silicon semiconductor layer, at a substrate temperature of $250^\circ$C and with excess gas being exhausted through the exhaust system 11. The deposition speed was $4.5 \times 10^{-9}$ m/s (45 Å/sec). This deposition speed is 30 times larger than that obtained with a plasma CVD system alone, namely around $1.5 \times 10^{-10}$ m/s (1.5 Å/sec).

A dark conductivity of $4 \times 10^{-10}$ Scm$^{-1}$ and a photo conductivity of $6 \times 10^{-5}$ Scm$^{-1}$ (AM:100mW/cm$^2$) was obtained as electric characteristics of an amorphous silicon layer thus produced which was devoid of dopant. These conductivities are equivalent to those obtained by a plasma CVD deposition system. If a solar cell were to be manufactured with a p-i-n junction, and the i-layer were to be fabricated according to the above-described method, then a high photoelectric conversion efficiency would be expected.

A non-monocrystalline semiconductor, $Si_xC_{1-x}$ - ($0<x<1$) of p-type conductivity could be fabricated largely under the same conditions as above-described except that as the productive gas, a reactive gas composed of $H_2Si(CH_3)_2/SiH_4 = 1/7$ and a gas composed of $B_2H_6/SiH_4 = 5/1000$ were introduced into the reaction space 1. The output power of the microwave oscillator 3 was 300 W. The substrate temperature was kept at 180 °C under a pressure of $4 \times 10^{-2}$ Pa ($3 \times 10^{-4}$ torr). As a result, an optical energy gap of 2.4 eV and a dark conductivity of $3 \times 10^{-6}$ Scm$^{-1}$ was obtained.

For the manufacture of an n-type microcrystalline semiconductor, largely the same operating conditions might again be utilized except that the productive gas was $SiH_4/H_2 = 1/5$ to $1/40$, preferably $1/30$ at a pressure of $4 \times 10^{-2}$ Pa ($3 \times 10^{-4}$ torr). The output power of the microwave oscillator was 400 W. The substrate temperature was 250 °C. As a result, an optical energy gap of 1.65 eV and an electric conductivity of 50 Scm$^{-1}$ was obtained. Because the ECR system has no sputtering effect even with high microwave power, the average crystal size tends to increase rendering a deposited layer more polycrystalline so that the crystallization rate is increased to 70% as compared to only 50% according to a glow discharge plasma CVD system. Further the semiconductor layer thus formed according to the experiment had a finely fabricated microcrystalline structure even with the reaction gas comprising $SiH_4/H_2 = 1/5$ to $1/40$.

A $SiO_{2-x}$ ($0 \leq x < 2$) or $Si_3N_{4-x}$ ($0 \leq x < 4$) layer was deposited by the method above described except that oxygen gas and nitrogen gas were introduced into the resonant space together with argon gas. Further $SiH_4$ gas was introduced into the reaction chamber 1 through the line 16. The ratio of the introduced oxygen gas or nitrogen gas to the introduced $SiH_4$ determines the value of X. When $X = 0$ was desired corresponding to $SiO_2$ or $Si_3N_4$, an amount of oxygen gas or nitrogen gas equivalent to the amount of $SiH_4$ was introduced.

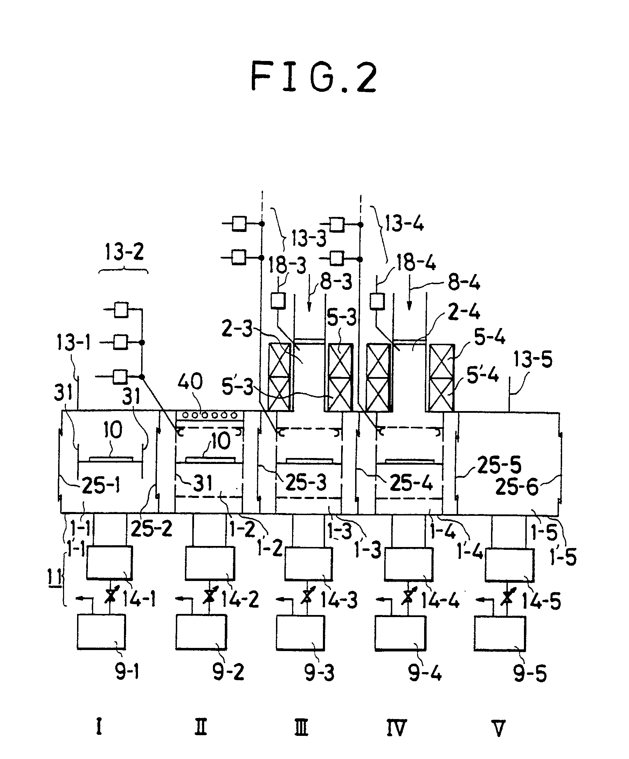

Referring now to Fig. 2, a system used in a method of the invention is shown. A semiconductor layer with a p-i-n junction or an n-i-p junction can be fabricated by means of the multi-chamber system.

The multi-chamber system as shown is comprised of five sections. The first section I is devoted to a loading chamber 1'-1. The second section II is devoted to a second chamber 1'-2, for example to deposit p-type layers. The third section III is devoted to a third chamber 1'-3, for example to deposit i-type layers. The fourth section IV is devoted to a fourth chamber 1'-4, for example to deposit n-type layers. The fifth section V is devoted to an unloading chamber 1'-5. For fabrication of n-i-p junctions, the sections II and IV would be interchanged.

Each chamber is provided with a doping system 13-1, 13-2,...13-5 and an evacuating system 11 comprising a turbo molecular pump 14-1, 14-2,... 14-5 and a vacuum pump 9-1, 9-2,...9-5. Each of the intermediate three chambers is formed with a reaction space 1-2, 1-3, 1-4 respectively. The second section II is a photo CVD system which is provided with a mercury lamp 40 and halogen lamps disposed in opposed relation relative to each other in a direction perpendicular to the plane of the drawing with the reaction chamber therebetween. The third and fourth sections are ECR enhanced CVD systems each of which is configured as in Fig. 1 and is equipped with a Helmholtz coil 5-3, 5-4 and a microwave oscillator (not shown). Argon gas may be employed as a resonating gas, as above described, but hydrogen gas may also be used in which case the magnitude of the magnetic field would have to be increased in inverse proportion to molecular weight.

Gate valves 25-2, 25-3,...25-5 are disposed between adjacent chambers and the substrate holder 31 is arranged to be transported from one chamber to another through the respective gate valve when it is open. During deposition, of course, the valves are kept closed. The entrance valve 25-1 and the take-out valve 25-6 are, however, opened during deposition to enable new substrates to be loaded on to the holder in the loading chamber 1'-1 via the entrance valve and to enable the substrate which has been deposited upon in the chambers 1'-2, 1'-3 and 1'-4 to be removed.

The deposition processes in the reaction spaces 1-3 and 1-4 might be carried out according to the particular methods above described. After completion of deposition in the reaction spaces 1-2, 1-3 and 1-4, the supply of the productive gas and radiation of microwave energy are halted and the substrate holders 31 are transported by a transportation means (not shown in the figure) to the next adjacent chamber with the valves 25-1 and 25-6 closed. The transporting step is carried out swiftly without extracting the gaseous atmosphere inside each chamber. The resonating gas, argon gas, may or may not be continuously introduced. After the transportation is completed, the next deposition process is carried out respectively in the chambers 1'-2, 1'-3 and 1'-4 with the valves 25-2 to 25-5 closed. By virtue of the above process, the semiconductor layers thus deposited are less contaminated and oxidized on their p-i and i-n junctions as compared with those formed by prior art glow discharge plasma CVD systems.

As an example, a solar cell thus formed might have a conversion efficiency of 12.9%, an open circuit voltage of 0.92 V and a short circuit current density of 18.4 mV/cm$^2$, with an effective area of 1.05 cm$^2$. Such a high conversion efficiency is possibly attributed to the fact that no sputtering with the reactive gas takes place in the ECR/CVD system. Further, it can be considered as another reason for the high conversion efficiency that the pressure in the chamber during deposition is only of the order of $1.333 \times 10^{-1}$ to $1.333$ to $10^{-3}$ Pa (1 $\times$ $10^{-3}$ to $1 \times 10^{-5}$ torr), $4 \times 10^{-2}$ Pa ($3 \times 10^{-4}$ torr) for example, which is lower than that obtained in a glow discharge plasma system, enabling impurity gas and reactive gas to be exhausted by the turbo pump after deposition in a time which is reduced by a factor of 100 in comparison with the time required in a glow discharge CVD system.

In the embodiment of Fig. 2, the gate valves 25-3 and 25-4 may be omitted from the system. In this case, buffer spaces might be provided between the respective chambers to improve the productivity of the system and the adjacent chambers might be substantially isolated by means of side walls of the holder 31. An exemplary solar cell fabricated according to this modification had a conversion efficiency of 12.6%, an open voltage of 0.93 V, a short current density of 18.3 mA/cm$^2$ and a fill factor of 0.81, with its area of 1.05 cm$^2$. Beside cost saving, it is made possible to transport the holder to the adjacent chamber within 5 minutes if the two valves 25-3 and 25-4 are dispensed with, thereby increasing the throughput of the system. Further, according to this embodiment, only one to three pinholes of about 0.1 to 0.01 micron in diameter are observed in the dark field of a microscope with a magnification factor of 100, which is 1/10 of that observed on a layer deposited by a glow discharge method.

The invention is also advantageous when applied to a process for manufacturing insulated-gate FETs of thin film type. In this case, the second section II is devoted to a reaction space in which is formed a semiconductor layer. The third section III is devoted to a reaction space in which is formed a silicon nitride layer. The fourth section IV is devoted to a reaction space in which is formed a silicon oxide layer. Each formation process is substantially the same as described supra.

It will be appreciated that various modifications could be made to the described embodiments without departing from the scope of the invention.

For example, a glow discharge CVD system could be employed as a second section II in the embodiment of Fig. 2 instead of the photo enhanced CVD system.

The present invention can be applied to light emitting MISs, super lattice light emitting devices and so on. As further applications, the invention is advantageous for other semiconductor lasers or optical integrated circuit devices.

Although the ECR system in the embodiment is combined with a glow discharge CVD system, a photo enhanced CVD system could instead be incorporated with the ECR system. In this case, an excimer laser having a wavelength of 100 to 400 nm, an argon laser, a nitrogen laser and so on might be used as a light source.

As a productive gas, disilane or a mixture of monosilane and $Si_2F_6$ may be used. This would be expected to improve the deposition speed even more.

The substrate may be of silicon semiconductor, glass, synthetic resin, stainless steel or those which are provided with an electrode thereon.

As a semiconductor to be deposited, $Si_xGe_{1-x}$ - (O<x<1), $Si_xSn_{1-x}$ (O<x<1), $C_xGe_{1-x}$ (O<x<1), either in their intrinsic or impurity doped semiconductor states can be used.

A substrate holder capable of holding a plurality of substrates as shown in Fig. 1 can be used for the multi-chamber system as shown in Fig. 2.

## Claims

1. A method of fabricating a semiconductor device of the thin film type including at least an insulating layer adjacent a semiconducting layer, comprising the steps of:

   CVD forming one of the layers in a first chamber on a substrate;

   transferring the substrate with the layer formed thereon from the first chamber to a second chamber;

   isolating the second chamber from the first chamber; and

   CVD forming in the second chamber the other of said layers to thereby form the adjacent insulating and semiconducting layers of the semiconductor device.

2. A method as claimed in claim 1 wherein said semiconductor device is an insulated gate-field effect transistor of the thin film type.

3. A method as claimed in claim 1 or 2 wherein said insulating layer comprises silicon nitride.

4. A method as claimed in any preceding claim wherein the CVD step utilized to form at least said insulating layer includes utilizing a magnetic field and microwave energy.

5. A method as claimed in claim 4 wherein said CVD step comprises electron cyclotron resonance CVD.

6. A method as claimed in any preceding claim wherein at least plasma CVD is effected in one of said chambers.

7. A method as claimed in any preceding claim wherein photo CVD is effected in one of said chambers.

8. A method as claimed in any preceding claim wherein the layer formed in the first chamber is semiconducting and the layer formed in the second chamber is insulating.

9. A method as claimed in any preceding claim wherein a third layer of the semiconductor device is formed in a third chamber after the layered member formed in the second chamber is transferred to the third chamber and the second and third chambers are isolated from one another.

10. A method as claimed in claim 9 wherein said third layer is insulating.

11. A method as claimed in claim 10 wherein said third layer comprises $S_iO_2$.

12. A method as claimed in any one of claims 9 to 11, wherein CVD forming is used to form the third layer in the third chamber.

13. A method as claimed in any preceding claim, wherein said substrate is a first substrate, and wherein a second substrate is transported to the first chamber at the same time as the first substrate is transferred to the second chamber, the method including the step of CVD forming said one layer on the second substrate in the first chamber while at the same time CVD forming in the second chamber said other of said layers.

14. A method as claimed in any one of claims 9 to 12, wherein said substrate is a first substrate, and wherein a second substrate is transported to the first chamber at the same time as the first substrate is transferred to the second chamber, the method including the step of CVD forming a layer on the second substrate in the first chamber while at the same time CVD forming in the second chamber a layer on said first substrate, and wherein the first substrate is transferred from the second chamber to the third chamber while at the same time the second substrate is transported to the second chamber and a third substrate is transported to the first chamber, the method further including the step of CVD forming a layer on the third substrate in the first chamber at the same time as a layer is formed on the third substrate in the first chamber and a layer is formed on the second substrate in the second chamber.

15. A semiconductor device manufacturing system comprising:
a first CVD system having a first reaction chamber in which a CVD process may be carried out;
a second CVD system having a second reaction chamber in which a microwave enhanced CVD process may be carried out, said first and second reaction chambers being capable of communication with each other;
a substrate holder on which a substrate may be mounted; and
a transportation means for transporting said holder from the inside of said first chamber to the inside of said second chamber without exposure to the atmosphere external of said chambers.

16. A semiconductor device manufacturing method comprising:
mounting a substrate on a substrate holder;
disposing said holder in a first reaction chamber;
carrying out a first CVD process in said first reaction chamber;
transporting said holder from said first chamber to a second reaction chamber without exposing said substrate to contact with atmospheric air; and
carrying out a second chemical reaction enhanced by microwave energy in said second reaction chamber.

17. A semiconductor device manufacturing system or process in accordance with which a plurality of semiconductor layers are deposited from the gaseous phase by a technique involving the injection of energy in the form of a gaseous component energized by magnetic and microwave energy.

# F I G.1

# FIG.2

European
Patent Office

**EUROPEAN SEARCH
REPORT**

Application Number

**EP 91 20 2023**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 594 227  (OSWALD)<br>* column 4, line 45 - line 67; figure 3 * * column 5, line 35 - line 40 * | 1-3,8-14 | C 23 C 16/54<br>C 23 C 16/50<br>C 23 C 16/48<br>H 01 L 21/205 |
| | — — — | | |
| X | EP-A-0 109 808  (ENERGY CONVERSION DEVICES)<br>* page 10, line 5 - line 14; claim 1 * | 15,16 | |
| | — — — | | |
| A | GB-A-2 076 587  (NIPPON TELEGRAPH AND TELE-PHONE)<br>* claim 1 * | 4,5,17 | |
| | — — — | | |
| A | EP-A-0 095 275  (ENERGY CONVERSION DEVICES)<br>* claim 1 * | 7 | |
| | — — — | | |
| A | US-A-4 492 605  (ISHIHARA ET AL)<br>* column 4, line 36 - column 5, line 38 * | 13,14 | |
| | — — — — — | | TECHNICAL FIELDS SEARCHED (Int. Cl.5) |
| | | | C 23 C<br>H 01 L |

The present search report has been drawn up for all claims

| Place of search | Date of completion of search | Examiner |
|---|---|---|
| The Hague | 20 September 91 | PATTERSON A.M. |